# EUROPÄISCHE PATENTSCHRIFT

(11) **EP 2 725 883 B1**
(45) Veröffentlichungstag und Bekanntmachung des Hinweises auf die Patenterteilung: **12.07.2017**
(21) Anmeldenummer: 13005121.2
(22) Anmeldetag: 28.10.2013
(51) Int. Cl.: H05K 7/20

(54) **Elektroantriebsbaueinheit mit Kühlvorrichtung**
Electric drive construction unit with cooling arrangement
Unité de construction d'entraînement électrique avec système de refroidissement

(30) Priorität: 29.10.2012 DE 102012021155
(43) Veröffentlichungstag der Anmeldung: 30.04.2014
(73) Patentinhaber: Airbus Defence and Space GmbH, 85521 Ottobrunn (DE)
(72) Erfinder: Christmann, Markus, 81375 München (DE); Hofmann, Michael, 85579 Neubiberg (DE); Krebs, Florian, 80538 München (DE)
(74) Vertreter: Kastel, Stefan

(56) Entgegenhaltungen:
- US-A- 5 770 903
- US-A1- 2012 266 612
- US-B1- 7 992 626

## Beschreibung

Die Erfindung betrifft eine Elektroantriebsbaueinheit, insbesondere eine Elektroantriebsbaueinheit für ein Flugzeug.

Aus der US 7 992 626 B1 ist ein Temperatur-Management-System zum Kühlen hitzeproduzierender Vorrichtungen, wie z.B. Mikroprozessoren, Schaltungsplatinen, Spannungswandler oder Stromversorgungen mit einer Sprüheinrichtung zum Sprühen der Vorrichtung mittels Kühlmedium und einem porösen Medium zum Speichern eines Teils des Kühlmediums bekannt. Das in dem porösen Medium gespeicherte Kühlmedium hilft, die Hitzeproduktion temporär bei einer Startprozedur zu managen, bis die Sprüheinheit betätigt werden kann.

Aus der US 2012/0266612 A1 ist ein thermisches System bekannt, bei dem zwischen einem Verdampfer und einem Kondensator in einem Kühlmittelkreislauf ein Behälter für das Kühlmittel vorgesehen ist, wobei ein Elektromotor in dem Behälter untergebracht sein kann. Hierdurch wird dauerhaft Wärmeenergie zwischen dem Elektromotor und dem Kühlmittel übertragen. Es ist eine Ausführungsform angesprochen, bei der ein Kühlsystem in Verbindung mit einem Fahrzeug, auch einem Luftfahrzeug, mit einem Verbrennungsmotor verwendet werden kann, um eine oder mehrere Komponenten oder Systeme und/oder den Motor des Fahrzeuges zu kühlen.

Aus der US 5 770 903 ist ein sich unter Lastbedingungen erwärmender Elektromotor zum Antreiben von Steuerflächen eines Flugzeuges mit einem geschlossenen Kühlsystem bekannt, umfassend eine Speichereinrichtung für ein Kühlmedium zum Kühlen zumindest eines Teilbereichs des Elektromotors mittels Phasenübergang. Insbesondere ist in einer den Elektromotor umgebenden Kammer ein flüssiges Kühlmedium, welches zum Kühlen verdampfen kann und zusätzlich noch ein weiteres Latentwärmespeichermedium vorgesehen.

In Luftfahrzeugen werden zunehmend elektronische Bauteile eingesetzt, dies betrifft auch Bereiche des Antriebs eines Luftfahrzeugs.

Statt gewöhnlicher Verbrennungsmotoren mit mechanischem Getriebe können daher beispielsweise Elektromotoren und/oder zumindest teilweise elektronische Getriebe zum Antrieb eines Luftfahrzeuges verwendet werden.

Aus Sicherheitsgründen sind für den Antrieb eines Luftfahrzeuges sowohl bei der Verwendung von klassischen Verbrennungsmotor-Aufbauten als auch bei der Verwendung von elektronischen Antriebsbauteilen zumeist mehrere unabhängige Antriebe vorgesehen, so dass im Falle eines teilweisen oder vollständigen Ausfalls eines Antriebs die übrigen Antriebe oder Antriebsbauteile dessen Antriebskraft übernehmen können. So ist es dem Piloten des Luftfahrzeuges möglich, das Luftfahrzeug zu stabilisieren und beispielsweise eine Notlandung oder einen Übergang in einen energiesparenderen Flugmodus durchzuführen.

Dadurch dass die bzw. das noch funktionierende Antriebsbauteil die Antriebskraft des ausgefallenen Antriebs oder Antriebsbauteils übernimmt, arbeiten die oder das Antriebsbauteil zumindest zeitweise oberhalb ihrer Dauerleistung und somit in Überlast.

Bei Elektromotoren ist es jedoch nur begrenzt möglich, sie für einen längeren Zeitraum oberhalb ihrer Dauerleistung in Überlast zu betreiben.

Weitere Bauelemente, die die Möglichkeit, Elektromotoren in Überlast zu betreiben, steigern, sind in der Luftfahrt jedoch unerwünscht, da sie die Gesamt-Gewichtslast erhöhen, was zu einem erhöhten Kraftstoffverbrauch des Luftfahrzeugs führt.

Aufgabe der Erfindung ist es daher, eine verbesserte Elektroantriebsbaueinheit zur Verwendung für den Antrieb eines Luftfahrzeugs bereitzustellen.

Diese Aufgabe wird durch eine Elektroantriebsbaueinheit gemäß Anspruch 1 gelöst.

Vorteilhafte Ausgestaltungen der Erfindung sind Gegenstand der Unteransprüche. Vorteilhafte Verwendungen sind in Anspruch 14 und 15 angegeben.

Eine sich unter Lastbedingungen erwärmende Elektroantriebsbaueinheit für ein Luftfahrzeug umfasst eine Speicher- und/oder Leiteinrichtung für ein Kühlmedium zum Kühlen zumindest eines Teilbereichs der Elektroantriebsbaueinheit mittels Phasenübergang.

Damit lässt sich insbesondere eine Elektroantriebsbaueinheit bereitstellen, die in einem Zeitraum, der für Notfallmaßnahmen ausreichend ist, oberhalb ihrer Dauerleistung betrieben werden kann.

Durch Kühlung der Elektroantriebsbaueinheit oder zumindest eines erhitzten Teilbereichs davon ist es möglich, die Elektroantriebsbaueinheit zumindest für einen vorbestimmten Zeitraum oberhalb ihrer Nenndauerleistung und auch in Überlast zu betreiben, ohne dass sie dabei beschädigt wird.

Bislang verwendete Kühlsysteme basieren auf der Ableitung von Wärme durch das Baudesign von Elektroantriebsbaueinheit oder Teilbereichen davon, beispielsweise durch Verwendung von Lamellen, die an Teilbereichen von Elektroantriebsbaueinheiten angebracht werden. Je größer jedoch die Wärmeableitungskapazität dieser zusätzlichen Bauelemente sein muss, desto größer ist gewöhnlich auch ihre Masse. In Luftfahrzeugen ist es jedoch wünschenswert, dass sämtliche verwendete Baueinheiten möglichst leicht sind. Daher sind die bisher bekannten Kühlsysteme für die Verwendung in Luftfahrzeugen weniger geeignet.

Durch die nun vorgeschlagene Speicher - und/oder Leiteinrichtung, in der ein Kühlmedium geführt und/oder gespeichert wird, wird ein alternatives Kühlsystem geschaffen, das im Vergleich zu üblichen Kühlsystemen deutlich leichter ist und somit besser für den Einsatz in Luftfahrzeugen geeignet ist.

Das Kühlmedium kann anhand seiner Phasenübergangstemperatur an zu erwartende Überlasttemperaturen angepasst eingesetzt werden, wobei der Phasenübergang des Kühlmediums von fest nach flüssig bzw. flüssig nach gasförmig in einem vorbestimmten Temperaturbereich stattfindet. So kann durch Verwendung eines minimalen Anteils an Kühlmedium in der Speicher- und/oder Leiteinrichtung eine maximale Wärmeentwicklung abgepuffert werden, ohne dabei die Gewichtslast der Elektroantriebsbaueinheit signifikant zu erhöhen.

Insgesamt wird demnach eine Elektroantriebsbaueinheit vorgeschlagen, die bei nur geringfügiger Gewichtserhöhung für einen vordefinierten Zeitraum in Überlast betrieben werden kann, weil sie durch den Phasenübergang des Kühlmediums in der Speicher- und/oder Leiteinrichtung gekühlt wird.

In bevorzugter Ausgestaltung ist die Elektroantriebsbaueinheit ein Elektromotor oder ein Teil eines Elektromotors oder eine Abtriebskomponente zum Übertragen von Drehmoment von einem Elektromotor zu einem anzutreibenden Element des Luftfahrzeuges.

Bevorzugt wird zumindest ein Teilbereich der Elektroantriebsbaueinheit durch das Kühlmedium gekühlt, um so vorteilhaft die Leistung der gesamten Elektroantriebsbaueinheit auf der gewünschten Höhe halten zu können.

Der zumindest eine Teilbereich der Elektroantriebsbaueinheit umfasst beispielsweise einen Läufer und/oder einen Ständer eines Elektromotors. Der Teilbereich kann zusätzlich oder alternativ auch eine Spule und/oder einen Kern eines Elektromotors umfassen. Zusätzlich oder alternativ kann der Teilbereich ein Leistungselektronikbauelement und/oder ein Lager eines Elektromotors oder eines Getriebes und/oder wenigstens eine Getriebekomponente, insbesondere im Abtrieb eines Elektromotors, umfassen.

Je nach zu erwartenden Überlasttemperaturen können vorteilhaft einzelne oder alle der genannten Baueinheiten die Speicher - und/oder Leiteinrichtung mit dem Kühlmedium umfassen.

Vorteilhaft umfasst die Speicher- und/oder Leitvorrichtung eine Rohrleitungsanordnung zum Leiten des Kühlmediums von einem Kühlmediumsspeicher zu dem wenigstens einen Teilbereich.

So kann das Kühlmedium vorzugsweise beabstandet zu dem zu kühlenden Teilbereich gespeichert werden und vorzugsweise erst zu dem Zeitpunkt zu dem Teilbereich geleitet werden, zu dem dieser Teilbereich eine Kühlung benötigt.

In bevorzugter Ausgestaltung umfasst die Speicher- und/oder Leiteinrichtung wenigstens einen austauschbaren und/oder wiederbefüllbaren Kühlmediumsspeicher.

So ist es bevorzugt möglich, im Kühlfalle das Kühlmedium zu verbrauchen, da es später vorteilhaft wieder ersetzt oder nachgefüllt werden kann.

Bevorzugt weist die Speicher- und/oder Leiteinrichtung wenigstens einen Kühlmediumsspeicher in Form eines in oder an dem zu kühlenden Teilbereich integral vorgesehenen Hohlraums wie insbesondere einer Bohrung auf.

Dabei ist es vorteilhaft möglich, das Kühlmedium nahe an dem zu kühlenden Teilbereich zu speichern, um es so im Kühlfalle vorzugsweise schnell und effektiv zu dem Teilbereich zu leiten.

Zusätzlich oder alternativ weist die Speicher - und/oder Leiteinrichtung wenigstens einen Kühlmediumsspeicher in Form eines anzuschließenden externen Kühlmediumsbehälters auf.

Damit ist es bevorzugt möglich, eine größere Menge an Kühlmedium zu speichern, da vorzugsweise keine Rücksicht auf begrenzten Bauraum in dem Teilbereich selbst genommen werden muss.

In vorteilhafter Ausgestaltung weist die Speicher- und/oder Leiteinrichtung ein poröses, insbesondere gesintertes, Material auf, wobei das Kühlmedium in Poren des porösen Materials angeordnet ist.

Mit einer solchen Ausgestaltung ist es vorteilhaft möglich, das Kühlmedium gleichmäßig über den zu kühlenden Teilbereich der Elektroantriebsbaueinheit zu verteilen und somit vorteilhaft eine effektive Kühlung zu erreichen.

Vorzugsweise ist eine Benetzungseinrichtung, insbesondere Sprüheinrichtung, vorgesehen, um den wenigstens einen zu kühlenden Teilbereich mit Kühlmedium aus der Speicher- und/oder Leitvorrichtung zwecks Kühlung durch Phasenübergang zu benetzen.

Durch Benetzung des zu kühlenden Teilbereichs mit Kühlmedium kann der Teilbereich vorteilhaft schnell und effektiv herab gekühlt werden, da das Kühlmedium bevorzugt auf der Oberfläche des Teilbereiches verdampft und die Verdampfungsenthalpie dem Teilbereich vorteilhaft Wärmeenergie entzieht.

Vorzugsweise ist die Elektroantriebsbaueinheit derart ausgebildet, dass die Kühlung durch das Kühlmedium automatisch bei Temperaturanstieg aktivierbar ist.

Vorzugsweise weist die Speicher- und/oder Leiteinrichtung wenigstens einen durch Temperaturanstieg zu öffnenden Verschluss auf.

So ist es vorteilhaft möglich, die Kühlung der Elektroantriebsbaueinheit durch den Temperaturanstieg in der Elektroantriebsbaueinheit selbst zu aktivieren und vorzugsweise erst dann das Kühlmedium mit dem zu kühlenden Teilbereich in Kontakt kommen zu lassen, wenn tatsächlich eine Kühlung erforderlich ist.

Beispielsweise weist der wenigstens eine Verschluss einen bei oberhalb einer vorgegebenen Grenztemperatur schmelzenden Stopfen auf.

In einer alternativen Ausführungsform oder zusätzlich weist der Verschluss eine durch Temperaturerhöhung und/oder durch bei Temperaturerhöhung entstehende Druckerhöhung zerreißbare Membran auf.

Alternativ oder zusätzlich weist der Verschluss ein Überdruckventil auf. Das Überdruckventil öffnet sich dabei vorteilhaft, wenn durch Temperatureinfluss ein Überdruck in dem Kühlmedium entsteht.

Alle drei genannten Alternativen bieten die Möglichkeit, die Kühlung vorteilhaft erst dann zu aktivieren, wenn sie tatsächlich erforderlich ist, und benötigen dabei vorzugsweise keine weiteren externen Sensoren.

Vorzugsweise ist das Kühlmedium derart ausgewählt, dass es bei Normalbetriebstemperatur flüssig oder fest ist und zwischen einer Normalbetriebstemperatur und einer kritischen Überlasttemperatur der Elektroantriebsbaueinheit einen Phasenübergang aufweist.

In flüssiger oder fester Form kann das Kühlmedium vorteilhaft platzsparend gespeichert werden. Erst bei der kritischen Überlasttemperatur vollzieht es vorzugsweise den Phasenübergang nach flüssig oder gasförmig und nimmt dabei der Enthalpie des Phasenübergangs entsprechend vorteilhaft Wärmeenergie von dem zu kühlenden Teilbereich auf.

Im Falle, dass die Elektroantriebsbaueinheit wieder in dem Bereich der Dauerleistung arbeitet, kann das Kühlmedium beispielsweise die aufgenommene Verflüssigungs- oder Verdampfungsenthalpie langsam an den Teilbereich abgeben, der diese dann vorteilhaft ableiten kann.

Vorzugsweise ist das Kühlmedium ausgewählt aus einer Gruppe, die niedrigschmelzende Salze, insbesondere mit einem Schmelzpunkt zwischen 60 °C und 350 °C, mehr insbesondere Alkalinitrit-Alkalinitrat-Gemische, Fluor-Inert-Verbindungen, nicht brennbare Flüssig-Kühlmedien, insbesondere Fluor-Ketone, und Flüssigkeiten Kältesprays, insbesondere aus nicht brennbaren Kältesprays, enthält.

Solche Materialien sind gut untersucht und vorteilhaft kostengünstig erhältlich, so dass sie einfach je nach den gegebenen Anforderungen als bevorzugte Kühlmedien eingesetzt werden können.

Vorzugsweise ist eine Kühlbetriebsanzeigeeinrichtung zum Erfassen und Anzeigen eines Kühlbetriebs vorgesehen.

In bevorzugter Ausgestaltung weist die Kühlbetriebsanzeigeneinrichtung eine Signalerzeugungseinrichtung zum Abgeben eines Kühlbetriebssignals an einen Bordcomputer eines Luftfahrzeuges und/oder an eine Anzeige zum Anzeigen des Kühlbetriebs in einem Luftfahrzeugcockpit auf.

So kann dem Piloten vorteilhaft angezeigt werden, dass Elektroantriebsbaueinheiten gesondert gekühlt werden und sich daher in einem Überlastzustand befinden.

Beispielsweise umfasst die Kühlbetriebsanzeigeeinrichtung einen Sensor zur Erfassung eines Kühlmittelabgabebetriebs der Speicher- und/oder Leitvorrichtung. Dies kann insbesondere ein Druck- oder Volumenänderungssensor sein.

Eine beispielhafte Ausführungsform eines solchen Sensors ist ein induktiver oder kapazitiver Annäherungsschalter zum Erfassen einer Druck- oder Volumenänderung des Kühlmediums.

Eine weitere beispielhafte Ausführungsform für einen solchen Sensor ist ein Sensor zur Betätigung des Verschlusses, wie z.B. ein Brückendraht in der zerreißbaren Membran und/oder ein durch das Überdruckventil aktivierbarer mechanischer Schalter.

Vorteilhafte Ausgestaltung der Erfindung werden nachfolgend anhand der beigefügten Zeichnungen näher erläutert. Darin zeigt:
- Fig. 1: ein Luftfahrzeug mit einer Elektroantriebsbaueinheit;
- Fig. 2: eine dreidimensionale Ansicht auf eine erste Ausführungsform der Elektroantriebsbaueinheit aus Fig. 1 mit einer Speicher- und/oder Leiteinrichtung für ein Kühlmedium;
- Fig. 3: eine Schnittansicht durch eine zweite Ausführungsform der Elektroantriebsbaueinheit aus Fig. 1 mit ruhendem Kühlmedium;
- Fig. 4: eine Schnittansicht durch die zweite Ausführungsform der Elektroantriebsbaueinheit aus Fig. 2 mit sich nach außen bewegendem Kühlmedium;
- Fig. 5: eine dritte Ausführungsform der Elektroantriebsbaueinheit aus Fig. 1 mit einer Speicher- und/oder Leiteinrichtung für ein Kühlmedium;
- Fig. 6: eine vierte Ausführungsform der Elektroantriebsbaueinheit aus Fig. 1 mit einer Speicher- und/oder Leiteinrichtung für ein Kühlmedium; und
- Fig. 7: ein Cockpit in dem Luftfahrzeug aus Fig. 1.

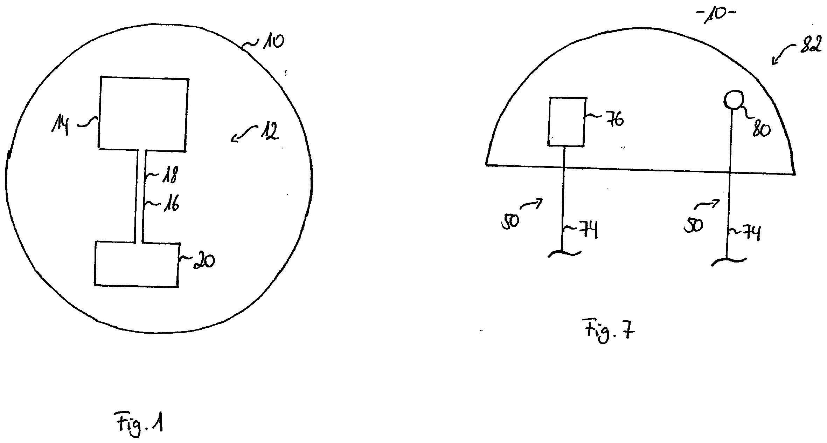

Fig. 1 zeigt ein Luftfahrzeug 10 mit einer Elektroantriebsbaueinheit 12, die einen Elektromotor 14 und ein Getriebe 16 mit Abtrieb 18 zum Antreiben eines Elementes 20 des Luftfahrzeugs 10 aufweist. Die Elektroantriebsbaueinheit 12 weist eine Notfallkühlvorrichtung 21 auf.

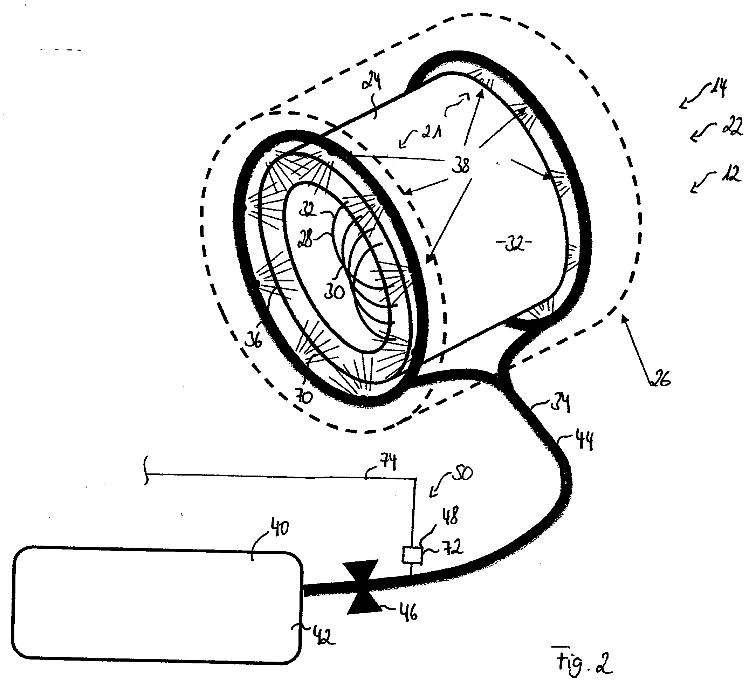

Fig. 2 zeigt eine erste Ausführungsform eines Teils 22 der Elektroantriebsbaueinheit 12, nämlich des Elektromotors 14.

Der Elektromotor 14 weist einen Kern 24 und ein Gehäuse 26 auf. An dem Kern 24 sind Endwicklungen 28 einer Spule 30 angebracht (schematisch dargestellt in Fig. 2).

Im Betrieb, insbesondere im Überlastbetrieb, erhitzt sich der Kern 24 bzw. weitere Teilbereiche 32 des Elektromotors 14, so dass eine Kühlung benötigt wird, um Beschädigungen der Elektroantriebsbaueinheit 12 zu vermeiden. Diese Kühlung wird durch die Notfallkühlvorrichtung 21 realisiert.

Die Notfallkühlvorrichtung 21 weist dazu eine in dem Gehäuse 26 angeordnete Speicher- und/oder Leiteinrichtung 34 für ein Kühlmedium 36 auf, alternativ kann die Speicher- und/oder Leiteinrichtung 34 aber auch in dem Kern 24 oder auch in anderen Teilbereichen 32 des Elektromotors 12 vorgesehen sein.

Die Speicher- und/oder Leiteinrichtung 34 umfasst in der in Fig. 2 gezeigten Ausführungsform äquidistant am Umfang des Gehäuses 26 angeordnete Benetzungseinrichtungen 38. Das Kühlmedium 36 kann über diese Benetzungseinrichtungen 38 auf einen oder mehrere der Teilbereiche 32 des Elektromotors 14 gesprüht werden, um den jeweils benetzten Teilbereich 32 zu kühlen.

Bei Kontakt mit dem erhitzten Teilbereich 32 nimmt das Kühlmedium 36 Energie in Form von Wärme von dem Teilbereich 32 auf, sodass die Verdampfungsenthalpie des Kühlmediums 36 erreicht werden kann. Das Kühlmedium 36 vollzieht einen Phasenübergang und geht im vorliegenden Fall von der flüssigen Phase in die gasförmige Phase über. Das Kühlmedium 36 dampft somit von dem Teilbereich 32 ab und entzieht dem Teilbereich 32 dabei Wärme, sodass der Teilbereich 32 effektiv herabgekühlt wird.

Die Speicher- und/oder Leiteinrichtung 34 wird bei der Ausführungsform in Fig. 2 von einem externen Kühlmediumsbehälter 40 gespeist. Der Kühlmediumsbehälter 40 bildet einen externen Kühlmediumsspeicher 42 und ist über eine Rohrleitungsanordnung 44 mit den Benetzungseinrichtungen 38 verbunden. Über ein Ventil 46 kann die Zuleitung von Kühlmedium 36 zu den Benetzungseinrichtungen 38 gesteuert werden. Das Kühlmedium 36 verbraucht sich während des Kühlvorgangs.

Deshalb kann der Kühlmediumsbehälter 40 von der Rohrleitungsanordnung 44 abgekoppelt und nach Verbrauch des Kühlmediums 36 wieder befüllt oder ausgetauscht werden. Er bildet somit einen wiederfüllbaren bzw. austauschbaren Kühlmediumsspeicher 42.

An der Rohrleitungsanordnung 44 ist ein Sensor 48 in Form einer Kühlbetriebsanzeigeeinrichtung 50 angordnet, die erfasst, ob Kühlmedium 36 zum Kühlen zu den Benetzungseinrichtungen 38 geleitet wird. Auf diesen Sensor 48, den auch die nachfolgend beschriebenen Ausführungsformen aufweisen, wird später genauer eingegangen.

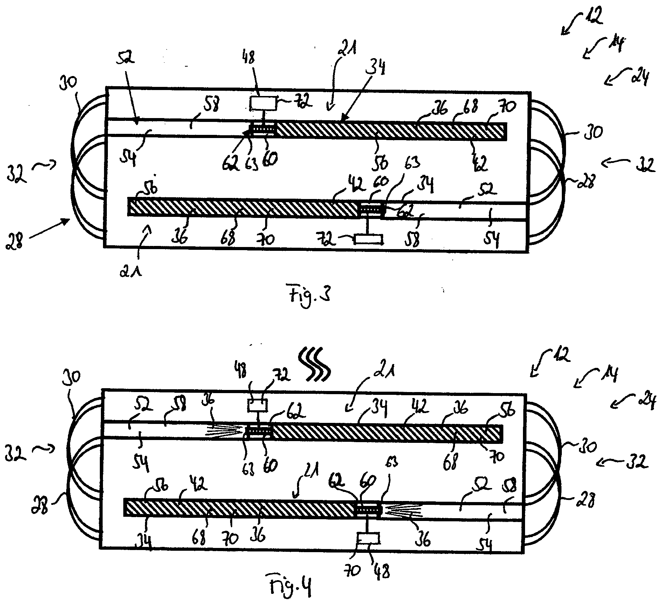

Fig. 3 und Fig. 4 zeigen eine zweite Ausführungsform der Elektroantriebsbaueinheit 12 im Längsschnitt durch den Kern 24.

Bei der zweiten Ausführungsform der Elektroantriebsbaueinheit 12 ist der Kühlmediumsspeicher 42 zum Speichern des Kühlmediums 36 nicht extern angeordnet, sondern ist durch einen integral in dem Kern 24 gebildeten Hohlraum 52 in Form einer Bohrung 54 ausgebildet.

Das Kühlmedium 36 ist in einem ersten Endbereich 56 der Bohrung 54 gelagert und von einem zweiten Endbereich 58 der Bohrung 54 durch einen Verschluss 60 abgetrennt. Der Verschluss 60 ist derart ausgebildet, dass er sich bei Temperaturerhöhung des Kerns 24 automatisch öffnet.

Im vorliegenden Beispiel wird der Verschluss 60 durch ein Überdruckventil 62 gebildet, wobei zusätzlich ein Stopfen 63 vorgesehen ist, der bei Temperaturerhöhung schmilzt. Es ist auch möglich, eine Membran (nicht gezeigt) anzuordnen, die reißt, wenn sich der Druck in dem Kühlmedium 36 durch die Temperaturerhöhung stark erhöht.

Fig. 3 zeigt die Elektroantriebsbaueinheit 12 der zweiten Ausführungsform bei Normalbetriebstemperatur. Das Kühlmedium 36 befindet sich verschlossen in dem ersten Endbereich 56 der Bohrung 54.

Bei einem Betrieb der Elektroantriebsbaueinheit 12 oberhalb ihrer Dauerleistung, d.h. in Überlast, erhitzt sich der Kern 24 und somit auch das darin eingebrachte Kühlmedium 36 in der Bohrung 54 auf eine kritische Überlasttemperatur.

Durch die Temperaturerhöhung auf die kritische Überlasttemperatur öffnet sich, wie in Fig. 4 gezeigt, der Verschluss 60 und ermöglicht es dem Kühlmedium 36, aus der Bohrung 54 auszutreten und einen Phasenübergang zu vollziehen. Dabei nimmt das Kühlmedium 36 Energie in Form von Wärme von dem Kern 24 auf und kühlt den Kern 24 somit herab. Das Kühlmedium 36 wird auch hier verbraucht und kann z.B. nach dem Kühlvorgang nachgefüllt werden.

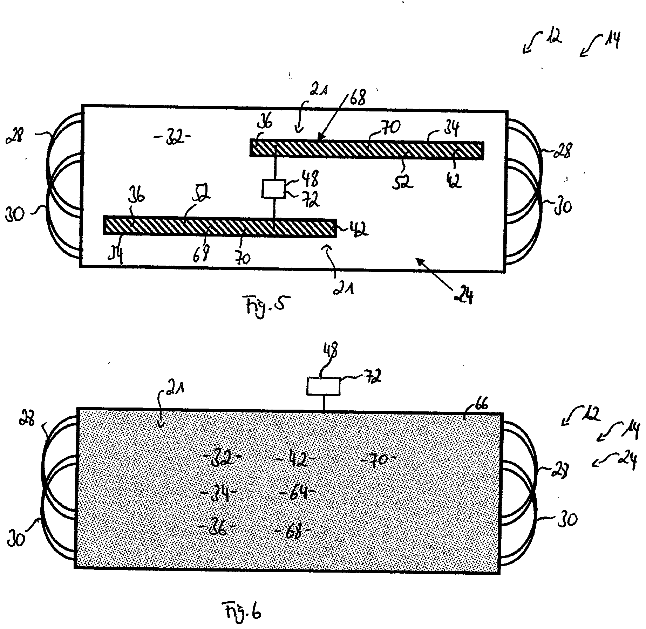

Fig. 5 zeigt eine dritte Ausführungsform der Elektroantriebsbaueinheit 12, wobei das Kühlmedium 36 in Hohlräumen 52 in dem Kern 24 angeordnet ist, die vollständig von dem Kernmaterial umschlossen sind.

Bei der in Fig. 5 gezeigten Ausführungsform verbraucht sich daher das Kühlmedium 36 nicht, wenn es den Kern 24 durch Phasenübergang kühlt, sondern verbleibt in dem Kern 24. Es nimmt lediglich beim Phasenübergang Energie von dem Kernmaterial auf und kühlt dieses so herab. Sobald die in Fig. 5 gezeigte Elektroantriebsbaueinheit 12 dann wieder im Normalbetrieb arbeitet, erfolgt ein umgekehrter Phasenübergang, wobei das Kühlmedium 36 wieder in seine ursprüngliche Phasenform zurückkehrt und dabei Energie in Form von Wärme an den Kern 24 abgibt, der diese Wärme dann ableitet.

Fig. 6 zeigt eine vierte Ausführungsform der Elektroantriebsbaueinheit 12, wobei der Kern 24 durch einen poröses, beispielsweise eine gesintertes, Material 64 gebildet ist. Das Kühlmedium 36 befindet sich dabei in Poren 66 des porösen Materials 64 und ist somit gleichmäßig in dem Kernmaterial verteilt. Es kann so effektiv Wärmeenergie von dem Kern 24 aufnehmen und für einen Phasenübergang nutzen.

Die in Fig. 2 bis Fig. 6 gezeigten Speicher- und/oder Leiteinrichtungen 34 können sowohl in einem Ständer, einem Läufer, in der Spule 30, in einem Lager oder auch in dem Kern 24 des Elektromotors 14, aber auch in einem anderen Leistungselektronikbauelement, besispielsweise in dem Getriebe 16 bzw. einer Getriebekomponente, beispielsweise im Abtrieb 18, angeordnet sein.

Das verwendete Kühlmedium 36 kann im Normalbetrieb sowohl in fester als auch in flüssiger Form vorliegen. Geeignet sind beispielsweise niedrig schmelzende Salze 68 mit einem Schmelzpunkt im Bereich der Überlasttemperatur. Vorteilhaft sind auch Fluor-Inert-Verbindungen oder Flüssigkeiten 70, wie sie beispielsweise in nicht brennbaren Kältesprays verwendet werden.

Alle gezeigten Ausführungsformen der Elektroantriebsbaueinheit 12 mit Speicher- und/oder Leiteinrichtung 34 weisen den Sensor 48 auf, der anzeigt, ob die Elektroantriebsbaueinheit 12 gerade gekühlt wird.

Der Sensor 48 kann dabei als Druck- oder Volumenänderungssensor 72 ausgebildet sein, der erfasst, ob sich der Druck oder das Volumen in dem Kühlmedium 36 verändert hat. Ein solcher Sensor 48 kann beispielsweise durch einen induktiven oder einen kapazitiven Annäherungsschalter gebildet sein.

Alternativ ist es im Falle der Verwendung einer zerreißbaren Membran auch möglich, den Sensor 48 beispielsweise in Form eines Brückendrahtes in der Membran anzuordnen, so dass er beim Zerreißen der Membran durchtrennt wird.

Weiter ist es auch möglich, einen mechanischen Schalter zu verwenden, der durch das Überdruckventil 62 betätigt wird.

Der Sensor 48 gibt über eine Signalerzeugungseinrichtung 74 ein entsprechendes Kühlbetriebssignal an einen in Fig. 7 gezeigten Bordcomputer 76 oder eine Anzeige 80 in einem Luftfahrzeugcockpit 82 aus, so dass dem Piloten angezeigt werden kann, ob die Elektroantriebsbaueinheit 12 bzw. zumindest Teilbereiche 32 davon gerade gekühlt werden.

Die oben beschriebene Elektroantriebsbaueinheit 12 bezieht sich auf redundante Elektromotoren 14.

Durch die zunehmende Elektrifizierung von Luftfahrzeugen 10 werden immer mehr Konzepte untersucht, bei denen Elektromotoren 14 für den Antrieb verwendet werden können.

Derzeitige Sicherheitsanforderungen werden dadurch erreicht, dass Luftfahrzeuge 10 mit mehr als einem Antrieb ausgestattet werden. In dem Fall, dass einer der Antriebe ausfällt, können die übrigen Antriebe für einen begrenzten Zeitraum oberhalb ihrer Dauerleistung betrieben werden. Dies ermöglicht es dem Piloten, das Luftfahrzeug 10 zu stabilisieren und Notfallmaßnahmen auszuführen, um beispielsweise das Luftfahrzeug 10 sicher zu landen oder auf eine Flughöhe zu bringen, in der weniger Energie verbraucht wird.

Die Verwendung von Elektromotoren 14 in Luftfahrzeugen 10 benötigt aus Sicherheitsgründen ein ähnliches Konzept. Wenn ein Teilbereich 32 des Motors oder der Motor als Ganzes ausfällt, werden die verbleibenden Motoren für einen begrenzten Zeitraum in Überlast betrieben. Die Dauer und Notfallbelastbarkeit hängen dabei vom Design des Motors ab.

Durch die vorliegende Elektroantriebsbaueinheit 12 ist es möglich, einen Elektromotor 14 oberhalb seiner Dauerleistung zu betreiben, da ein sehr effektives Notfall-Kühlsystem verwendet wird.

Normalerweise weisen Elektromotoren 14 nur begrenzte Möglichkeiten auf, oberhalb ihrer Dauerleistung betrieben zu werden. Die Dauer und Belastbarkeit hängt vom thermischen Design des Motors ab. Die Überlastfähigkeiten sind durch den Temperaturwiderstand der Motorkomponenten begrenzt. Sie hängen auch von dem verwendeten Kühlsystem ab, sofern ein Kühlsystem eingebaut ist.

Gewicht ist generell eine wichtige Beschränkung bei Elektromotoren 14 für Luftfahrzeuge 10, so dass diese Elektromotoren 14 dahingehend optimiert werden, dass sie so wenig wie möglich wiegen. Jedoch bedeutet eine geringere Masse auch eine geringere Fähigkeit, Hitze zu absorbieren, die emittiert wird, wenn der Elektromotor 14 seine Dauerleistung übersteigt. Daher wird die Dauer und Belastbarkeit im Überlastbetrieb geringer, wenn der Elektromotor 14 hinsichtlich eines geringeren Gewichtes optimiert worden ist.

Daher wird nun vorgeschlagen, ein System einzubauen, das eine sehr effektive Kühlung für einen begrenzten Zeitraum im Notfall bereitstellt. Das System ist derart ausgelegt, dass es beispielsweise nach Verwendung wieder aufgefüllt werden kann.

Das Notfallkühlsystem, d.h. die Notfallkühlvorrichtung 21, erlaubt den Betrieb eines Elektromotors 14 oder eines Getriebes 16 oberhalb der Dauerleistung für einen vorbestimmten Zeitraum. Die Dauer und Überlastbelastbarkeit kann derart angepasst werden, dass ein Luftfahrzeug 10 auf eine Flughöhe gebracht werden kann, in der es weniger Energie verbraucht, oder dass das Luftfahrzeug 10 gelandet werden kann.

Im Vergleich zu Motoren, die für höhere Belastungen ausgelegt sind, wird durch dieses Design Gewicht eingespart.

Elektronische Bauteile können beispielsweise durch Kühlsprays gekühlt werden. Solche Kühlsprays werden verwendet, um die Komponenten schnell herabzukühlen. Das Prinzip dabei ist der Phasenübergang von flüchtigen Flüssigkeiten, die auf heiße Komponenten aufgesprüht werden. Die Flüssigkeit verdampft rückstandsfrei und kühlt dabei die entsprechende Komponente.

Beispielsweise wird bei dem vorliegenden Notfallkühlsystem ein Netzwerk von dünnen Röhren in dem Motor bzw. dem Getriebe 16 eingebaut, das das Kühlmedium 36 zu kritischen Komponenten leiten kann. Die Röhren enden bei den kritischen Komponenten und setzen das Kühlmedium 36 frei, das sich auf den Komponenten verflüchtigt und somit die emittierte Wärme davon ableitet. Kritische Komponenten sind beispielsweise Spule 30, Wicklungen 28, Halbleiter, usw.

Das Kühlmedium 36 kann in einem oder mehreren Kühlmediumsbehältern 40 gespeichert werden, die ersetzt werden können, wenn das Kühlsystem verwendet worden ist. Die Größe der Kühlmediumsbehälter 40 kann dabei die Zeitspanne definieren, für die der Elektromotor 14 oberhalb seiner Dauerleistung betrieben werden kann.

Bei einer alternativen Ausführungsform ist das Kühlmedium 36 fest oder flüssig und ist in Ausnehmungen des Teilbereichs 32 beinhaltet, der gekühlt werden soll, zum Beispiel in Bohrungen 54 in einem Ständer oder Läufer des Elektromotors 14. Die Notfallkühlung wird in diesem Fall automatisch aktiviert, wenn die Umgebungstemperatur an dieser Stelle einen Grenzwert überschreitet, der oberhalb von erwarteten Temperaturen liegt, bei denen ein fehlerfreier Normalbetrieb erwartet wird. Nach Aktivierung durchläuft das Kühlmedium 36 eine Phasenänderung, beispielsweise von fest nach flüssig oder von flüssig nach gasförmig, und kühlt damit effektiv den Teilbereich 32, der gekühlt werden soll, zum Beispiel den Elektromotor 14.

Diese Phasenänderung kann direkt durch die Umgebungstemperatur oder durch eine Druckänderung oder durch eine Kombination von beiden initiiert werden.

Das Kühlsystem kann derart ausgelegt sein, dass ein Temperaturänderung einen Stopfen 63 schmilzt, der die Ausnehmung verschließt, in der das Kühlmedium 36 beinhaltet ist, wobei der Druck in dieser Ausnehmung verringert wird.

Alternativ kann die Ausnehmung durch wenigstens ein Überdruckventil 62 geschlossen sein. Ein flüssiges Kühlmedium 36 kann durch den entstehenden Druck, der sich bei Überlasttemperaturen aufbaut, durch das Überdruckventil 62 bzw. die Überdruckventile 62 gepresst werden.

Alternativ kann die Ausnehmung durch eine Membran verschlossen sein, die nach einer definierten Druckerhöhung in der Ausnehmung, die durch die Phasenänderung des Kühlmediums 36 ausgelöst wird, zerreißt.

Das Kühlsystem kann vorteilhaft Einrichtungen aufweisen, die seine Aktivierung in einem Computer oder dem Piloten eines Luftfahrzeuges 10, in dem es eingebaut ist, anzeigen.

Dies kann beispielsweise durch einen induktiven oder kapazitiven Annäherungsschalter realisiert sein, der eine Änderung des Volumens des Kühlmedium 36 in dessen Nähe erfasst.

Es kann auch durch einen Brückendraht gebildet werden, der durch das Zerreißen der Membran durchtrennt wird.

Alternativ kann auch ein mechanischer Schalter durch die Öffnung des Überdruckventiles 62 aktiviert werden.

Als Phasenübergangsmedien, d.h. Kühlmedien 36, können niedrig schmelzende Salze 68 oder Fluor-Inert-Verbindungen zum Einsatz kommen. Für einen Einsatz mit den schmalen Röhren sind Stoffe geeignet, wie sie bei nicht brennbaren Kältesprays verwendet werden.

### Bezugszeichenliste

- 10: Luftfahrzeug
- 12: Elektroantriebsbaueinheit
- 14: Elektromotor
- 16: Getriebe
- 18: Abtrieb
- 20: Element
- 21: Notfallkühlvorrichtung
- 22: Teil
- 24: Kern
- 26: Gehäuse
- 28: Endwicklung
- 30: Spule
- 32: Teilbereich
- 34: Speicher- und/oder Leiteinrichtung
- 36: Kühlmedium
- 38: Benetzungseinrichtung
- 40: Kühlmediumsbehälter
- 42: Kühlmediumsspeicher
- 44: Rohrleitungsanordnung
- 46: Ventil
- 48: Sensor
- 50: Kühlbetriebsanzeigeeinrichtung
- 52: Hohlraum
- 54: Bohrung
- 56: erster Endbereich
- 58: zweiter Endbereich
- 60: Verschluss
- 62: Überdruckventil
- 63: Stopfen
- 64: poröses Material
- 66: Pore
- 68: Salz
- 70: Flüssigkeit
- 72: Druck- oder Volumenänderungssensor
- 74: Signalerzeugungseinrichtung
- 76: Bordcomputer
- 80: Anzeige
- 82: Luftfahrzeugcockpit

## Patentansprüche

1. Sich unter Lastbedingungen erwärmende Elektroantriebsbaueinheit (12) zur Verwendung für den Antrieb eines Luftfahrzeugs (10), umfassend redundante Elektromotoren (14) und eine Notfallkühlvorrichtung (21), die eine Speicher- und/oder Leiteinrichtung (34) für ein Kühlmedium (36) zum Kühlen zumindest eines Teilbereichs (32) der Elektroantriebsbaueinheit (12) mittels Phasenübergang aufweist und die dazu ausgebildet ist, einen Überlastbetrieb eines Elektromotors (14) bei Ausfall eines weiteren Motors oder eines Teilbereichs (32) davon zu ermöglichen.

2. Elektroantriebsbaueinheit (12) nach Anspruch 1,
**dadurch gekennzeichnet, dass** die Speicher- und/oder Leiteinrichtung (34) eine Rohrleitungsanordnung (44) zum Leiten des Kühlmediums (36) von einem Kühlmediumsspeicher (42) zu dem wenigstens einen Teilbereich (32) umfasst.

3. Elektroantriebsbaueinheit (12) nach Anspruch 1 oder 2,
**dadurch gekennzeichnet,**
**dass** die Speicher- und/oder Leiteinrichtung (34) wenigstens einen austauschbaren und/oder wiederbefüllbaren Kühlmediumsspeicher (42) umfasst.

4. Elektroantriebsbaueinheit (12) nach einem der voranstehenden Ansprüche,
**dadurch gekennzeichnet,**
**dass** die Speicher- und/oder Leiteinrichtung (34) wenigstens einen Kühlmediumsspeicher (42) in Form
a) eines in oder an dem zu kühlenden Teilbereich (32) integral vorgesehenen Hohlraums (52), wie insbesondere einer Bohrung (54); und/oder
b) eines anzuschließenden externen Kühlmediumsbehälters (40) aufweist.

5. Elektroantriebsbaueinheit (12) nach einem der voranstehenden Ansprüche,
**dadurch gekennzeichnet, dass** die Speicher- und/oder Leiteinrichtung (34) ein poröses, insbesondere gesintertes, Material (64) aufweist, wobei das Kühlmedium (36) in Poren (66) des porösen Materials (64) angeordnet ist.

6. Elektroantriebsbaueinheit (12) nach einem der voranstehenden Ansprüche,
**dadurch gekennzeichnet,**
**dass** eine Benetzungseinrichtung (38), insbesondere Sprüheinrichtung, vorgesehen ist, um den wenigstens einen zu kühlenden Teilbereich (32) mit Kühlmedium (36) aus der Speicher- und/oder Leiteinrichtung (34) zwecks Kühlung durch Phasenübergang zu benetzen.

7. Elektroantriebsbaueinheit (12) nach einem der voranstehenden Ansprüche,
**dadurch gekennzeichnet, dass** die Speicher- und/oder Leiteinrichtung (34) wenigstens einen durch Temperaturanstieg zu öffnenden Verschluss (60) aufweist.

8. Elektroantriebsbaueinheit (12) nach Anspruch 7,
**dadurch gekennzeichnet,**
**dass** der wenigstens eine Verschluss (60) einen bei oberhalb einer vorgegebenen Grenztemperatur schmelzenden Stopfen (63), eine durch Temperaturerhöhung und/oder durch bei Temperaturerhöhung entstehende Druckerhöhung zerreißbare Membran und/oder ein Überdruckventil (62) aufweist.

9. Elektroantriebsbaueinheit (12) nach einem der voranstehenden Ansprüche,
**dadurch gekennzeichnet, dass** das Kühlmedium (36) derart ausgewählt ist, dass es bei Normalbetriebstemperatur flüssig oder fest ist und zwischen einer Normalbetriebstemperatur und einer kritischen Überlasttemperatur der Elektroantriebsbaueinheit (12) einen Phasenübergang aufweist.

10. Elektroantriebsbaueinheit (12) nach einem der voranstehenden Ansprüche,
**dadurch gekennzeichnet,**
**dass** das Kühlmedium (36) ausgewählt ist aus einer Gruppe, die niedrigschmelzende Salze (68), insbesondere mit einem Schmelzpunkt zwischen 60 °C und 350 °C, mehr insbesondere Alkalinitrit-Alkalinitrat-Gemische, Fluorinerte, nicht brennbare Flüssig-Kühlmedien, insbesondere Fluor-Ketone, und Flüssigkeiten (70) aus nicht brennbaren Kältesprays enthält.

11. Elektroantriebsbaueinheit (12) nach einem der Ansprüche 1 bis 10,
**dadurch gekennzeichnet, dass** eine Kühlbetriebsanzeigeeinrichtung (50) zum Erfassen und Anzeigen eines Kühlbetriebs vorgesehen ist.

12. Elektroantriebsbaueinheit (12) nach Anspruch 11,
**dadurch gekennzeichnet, dass** die Kühlbetriebsanzeigeneinrichtung (50) eine Signalerzeugungseinrichtung (74) zum Abgeben eines Kühlbetriebssignals an einen Bordcomputer (76) eines Luftfahrzeugs (10) und/oder an eine Anzeige (80) zum Anzeigen des Kühlbetriebs in einem Luftfahrzeugcockpit (82) aufweist.

13. Elektroantriebsbaueinheit (12) nach einem der Ansprüche 11 oder 12, insbesondere nach Anspruch 7 oder 8,
**dadurch gekennzeichnet, dass** die Kühlbetriebsanzeigeeinrichtung (50) einen Sensor (48) zur Erfassung eines Kühlmittelabgabebetriebs der Speicher- und/oder Leiteinrichtung (34), insbesondere einen Druck- oder Volumenänderungssensor (72), wie einen induktiven oder kapazitiven Annäherungsschalter, zum Erfassen einer Druck- oder Volumenänderung des Kühlmediums (36) und/oder einen Sensor (48) zur Betätigung des Verschlusses (60), wie z.B. einen Brückendraht in der zerreißbaren Membran und/oder einen durch das Überdruckventil (62) aktivierbaren mechanischen Schalter, aufweist.

14. Luftfahrzeug (10), das mit mehr als einem Antrieb für den Antrieb des Luftfahrzeuges ausgestattet ist, umfassend eine Elektroantriebsbaueinheit (12) nach einem der voranstehenden Ansprüche als einen der Antriebe.

15. Verwendung einer Elektroantriebsbaueinheit nach einem der Ansprüche 1 bis 13 für den Antrieb eines Luftfahrzeugs (10).

## Claims

1. Electric drive construction unit (12) warming under load conditions, for use in driving an aircraft (10), said unit comprising redundant electric motors (14) and an emergency cooling arrangement (21) comprising a storage and/or conduction device (34) for a cooling medium (36) for cooling at least a part (32) of said electric drive construction unit (12) by means of phase transition and configured to enable an overload operation of an electric motor (14) upon failure of another motor or a part (32) thereof.

2. Electric drive construction unit (12) according to claim 1,
**characterized in that** said storage and/or conducting device (34) comprises a pipe arrangement (44) for conducting said cooling medium (36) from a cooling medium storage (42) to said at least one part (32).

3. Electric drive construction unit (12) according to claim 1 or 2,
**characterized in that** said storage and/or conducting device (34) comprises at least one exchangeable and/or refillable cooling medium storage (42).

4. Electric drive construction unit (12) according to one of the preceding claims,
**characterized in that** said storage and/or conducting device (34) comprises at least one cooling medium storage (42) in the form of
a) a hollow space (52) such as, in particular, a bore (54), integrally provided in or at said part (32) to be cooled; and/or
b) an external cooling medium container (40) to be connected.

5. Electric drive construction unit (12) according to one of the preceding claims,
**characterized in that** said storage and/or conducting device (34) comprises a porous, in particular sintered, material (64), wherein said cooling medium (36) is disposed in pores (66) of said porous material (64).

6. Electric drive construction unit (12) according to one of the preceding claims, **characterized in that** a wetting device (38), in particular a spraying device, is provided, for wetting said at least one part (32) to be cooled with cooling medium (36) from said storage and/or conducting device (34) for the purpose of cooling by means of phase transition.

7. Electric drive construction unit (12) according to one of the preceding claims, **characterized in that** said storage and/or conducting device (34) comprises at least one closure (60) to be opened by a rise in temperature.

8. Electric drive construction unit (12) according to claim 7,
**characterized in that** said at least one closure (60) comprises a plug (63) melting at a temperature above a predefined threshold temperature, a membrane tearable by a rise in temperature and/or by a pressure increase caused when the temperature increases, and/or a pressure relief valve (62).

9. Electric drive construction unit (12) according to one of the preceding claims, **characterized in that** said cooling medium (36) is chosen in such a manner that said cooling medium is in a liquid or solid state at a normal operation temperature, and changes phase between a normal operation temperature and a critical overload temperature of said electric drive construction unit (12).

10. Electric drive construction unit (12) according to one of the preceding claims, **characterized in that** said cooling medium (36) is selected from the group comprising low-melting salts (68), in particular with a melting point between 60°C and 350°C, even more particular mixtures of alkali nitrite-alkali nitrate, fluorinated incombustible liquid cooling media, in particular fluoro-ketones, and liquids (70) from incombustible cold sprays.

11. Electric drive construction unit (12) according to one of the claims 1 to 10, **characterized in that** there is provided a cooling operation indicating device (50) for detecting and indicating a cooling operation.

12. Electric drive construction unit (12) according to claim 11,
**characterized in that** said cooling operation indicating device (50) includes a signal generating device (74) for providing a cooling operation signal to an onboard computer (76) of an aircraft (10), and/or an indicator (80) for indicating said cooling operation in an aircraft cockpit (82).

13. Electric drive construction unit (12) according to one of the claims 11 or 12, particularly according to claim 7 or 8,
**characterized in that** said cooling operation indicating device (50) includes a sensor (48) for detecting a cooling medium delivery operation of said storage and/or conducting device (34), in particular a pressure or volume-change sensor (72) such as an inductive or capacitive proximity switch, for detecting a change in pressure or volume of said cooling medium (36) and/or a sensor (48) for operating a closure (60), such as a bridgewire in said tearable membrane for example and/or a mechanical switch activated by said pressure relief valve (62).

14. Aircraft (10) equipped with more than one drive unit for driving an aircraft, comprising an electric drive construction unit (12) as defined in any one of the preceding claims, as one of said drive units.

15. Use of an electric drive construction unit according to one of the claims 1 to 13 for driving an aircraft (10).

## Revendications

1. Unité structurelle d'entraînement électrique (12) qui s'échauffe dans des conditions sous charge, destinée à être utilisée pour l'entraînement d'un aéronef (10), incluant des moteurs électriques redondants (14) et un dispositif de refroidissement de secours (21), lequel comprend un moyen d'accumulation et/ou un moyen de passage (34) pour un milieu de refroidissement (36) afin de refroidir au moins une zone partielle (32) de l'unité structurelle d'entraînement électrique (12) au moyen d'une transition de phase, et qui est réalisée pour permettre un fonctionnement en surcharge d'un moteur électrique (14) en cas de défaillance d'un autre moteur ou d'une zone partielle (32) de celui-ci.

2. Unité structurelle d'entraînement électrique (12) selon la revendication 1,
**caractérisée en ce que** le moyen d'accumulation et/ou de passage (34) inclut un agencement à conduite tubulaire (44) pour le passage du milieu de refroidissement (36) depuis un accumulateur de milieu de refroidissement (42) jusqu'à ladite au moins une zone partielle (32).

3. Unité structurelle d'entraînement électrique (12) selon la revendication 1 ou 2,
**caractérisée en ce que** le moyen d'accumulation et/ou de passage (34) inclut au moins un accumulateur de milieu de refroidissement (42) interchangeable et/ou reremplissable.

4. Unité structurelle d'entraînement électrique (12) selon l'une des revendications précédentes,
**caractérisée en ce que** le moyen d'accumulation et/ou de passage (34) comprend un accumulateur de milieu de refroidissement (42) sous la forme a) d'une cavité (52) prévue de manière intégrale dans ou sur la zone partielle (32) à refroidir, comme en particulier un perçage (54) ; et/ou b) d'un récipient de milieu de refroidissement (40) externe à raccorder.

5. Unité structurelle d'entraînement électrique (12) selon l'une des revendications précédentes,
**caractérisée en ce que** le moyen d'accumulation et/ou de passage (34) comprend un matériau poreux, en particulier fritté (64), et le milieu de refroidissement (36) est disposé dans des pores (66) du matériau poreux (64).

6. Unité structurelle d'entraînement électrique (12) selon l'une des revendications précédentes,
**caractérisée en ce qu'**il est prévu un moyen de mouillage (38), en particulier un dispositif de pulvérisation, afin de mouiller ladite au moins une zone partielle (32) à refroidir, au moyen d'un milieu de refroidissement (36) provenant du moyen d'accumulation et/ou de passage (34) dans le but d'un refroidissement par transition de phase.

7. Unité structurelle d'entraînement électrique (12) selon l'une des revendications précédentes, **caractérisé en ce que** le moyen d'accumulation et/ou de passage (34) comprend au moins un obturateur (60) à ouvrir par augmentation de température.

8. Unité structurelle d'entraînement électrique (12) selon la revendication 7,
**caractérisé en ce que** ledit au moins un obturateur (60) comprend un bouchon (63) fusible au-dessus d'une température limite prédéterminée, une membrane déchirée par augmentation de température et/ou par augmentation de pression apparaissant lors d'une augmentation de température, et/ou une valve de surpression (62).

9. Unité structurelle d'entraînement électrique (12) selon l'une des revendications précédentes,
**caractérisé en ce que** le milieu de refroidissement (36) est choisi de telle façon que, à température de fonctionnement normale, il est liquide ou solide et présente une transition de phase entre une température de fonctionnement normale et une température de surcharge critique de l'unité structurelle d'entraînement électrique (12).

10. Unité structurelle d'entraînement électrique (12) selon l'une des revendications précédentes,
**caractérisée en ce que** le milieu de refroidissement (36) est choisi parmi un groupe qui contient des sels à bas point de fusion (68), en particulier avec un point de fusion entre 60° C et 350° C, de façon plus particulière des mélanges de nitrites alcalins et de nitrates alcalins, des milieux de refroidissement liquides non combustibles inertes vis-à-vis du fluor, en particulier fluor-cétone, et des liquides (70) provenant de pulvérisations frigorigènes non combustibles.

11. Unité structurelle d'entraînement électrique (12) selon l'une des revendications 1 à 10,
**caractérisée en ce qu'**il est prévu un dispositif d'affichage de fonctionnement en refroidissement (50) pour détecter et afficher un fonctionnement en refroidissement.

12. Unité structurelle d'entraînement électrique (12) selon la revendication 11,
**caractérisée en ce que** le dispositif d'affichage de fonctionnement en refroidissement (50) comprend un dispositif de génération de signal (74) pour délivrer un signal de fonctionnement en refroidissement à un ordinateur embarqué (76) de l'aéronef (10) et/ou un affichage (80) pour afficher le fonctionnement en refroidissement dans le cockpit d'un aéronef (82).

13. Unité structurelle d'entraînement électrique (12) selon l'une des revendications 11 ou 12, en particulier selon la revendication 7 ou 8,
**caractérisée en ce que** le dispositif d'affichage de fonctionnement en refroidissement (50) comprend un capteur (48) pour détecter un fonctionnement en fourniture de milieu de refroidissement du moyen d'accumulation et/ou de passage (34), en particulier un capteur de variation de pression ou de variation de volume (72), comme un capteur de proximité inductif ou capacitif, afin de détecter une variation de pression ou de volume du milieu de refroidissement (36) et/ou un capteur (48) pour actionner l'obturateur (60), comme par exemple un fil de pontage dans la membrane déchirable et/ou un commutateur mécanique susceptible d'être activé par la valve de surpression (62).

14. Aéronef (10), qui est équipé avec plus d'un entraînement pour l'entraînement de l'aéronef, incluant une unité structurelle d'entraînement électrique (12) selon l'une des revendications précédentes, constituant l'un des entraînements.

15. Utilisation d'une unité structurelle d'entraînement électrique selon l'une des revendications 1 à 13 pour l'entraînement d'un aéronef (10).
